(19) **Europäisches Patentamt**

**European Patent Office**

**Office européen des brevets**

(11) **EP 0 792 027 B1**

(12) **FASCICULE DE BREVET EUROPEEN**

(45) Date de publication et mention
de la délivrance du brevet:
**14.04.2004 Bulletin 2004/16**

(51) Int Cl.⁷: **H04B 1/40**, H03H 7/42

(21) Numéro de dépôt: **97200400.6**

(22) Date de dépôt: **13.02.1997**

(54) **Appareil de radio-téléphonie multibande**

Mehrband-Funkgerät

Multi-band radio-telephone apparatus

(84) Etats contractants désignés:
**DE FR GB**

(30) Priorité: **21.02.1996 FR 9602150**

(43) Date de publication de la demande:
**27.08.1997 Bulletin 1997/35**

(73) Titulaire: **Koninklijke Philips Electronics N.V.
5621 BA Eindhoven (NL)**

(72) Inventeurs:
• **Lecuyer, Mathieu
75008 Paris (FR)**

• **Lagoguez, Bruno
75008 Paris (FR)**

(74) Mandataire: **Charpail, François et al
Société Civile SPID,
156, Boulevard Haussmann
75008 Paris (FR)**

(56) Documents cités:
**EP-A- 0 624 004           EP-A- 0 653 851
EP-A- 0 682 458           FR-A- 917 372
FR-A- 2 685 586           US-A- 4 731 877**

## Description

La présente invention concerne un appareil de radio-téléphonie agencé pour émettre ou recevoir des signaux dans une première ou une deuxième gammes de fréquences, qui comprend un premier système d'antenne et de filtrage destiné à assurer l'émission ou la réception de signaux dans la première gamme de fréquences, un deuxième système d'antenne et de filtrage destiné à assurer l'émission ou la réception de signaux dans la deuxième gamme de fréquences, et un dispositif de sélection de la gamme de fréquences utilisée ainsi qu'un dispositif de gestion de fréquences pilotant ledit dispositif de sélection, appareil dans lequel une conversion de fréquence, à partir de l'une des deux gammes de fréquences vers une fréquence intermédiaire, est réalisée au moyen d'un unique oscillateur local et d'un unique mélangeur.

Un appareil de radio-téléphonie susceptible de fonctionner selon deux sytèmes de transmission ayant des caractéristiques différentes, par exemple les spécifications GSM et DECT, a déjà été proposé. Dans le document EP-A-653 851 il est indiqué que dans ce cas, une fréquence intermédiaire pouvait être avantageusement choisie comme étant sensiblement égale à la moitié de la différence de fréquences entre les deux gammes de fréquences. Un tel appareil ne requiert qu'un unique oscillateur local, ainsi qu'un unique mélangeur qui opèrent alors, à partir d'une fréquence médiane entre les deux gammes, un changement par valeur inférieure depuis la fréquence d'émission-réception la plus élevée, et par valeur supérieure depuis la fréquence d'émission-réception la plus basse. On évite ainsi d'avoir à doubler certaines fonctions de l'appareil ce qui le rend plus économique.

D'autres fonctions ont été considérées jusqu'à présent comme étant difficiles à mettre en commun aux deux systèmes de transmission du fait que ces fonctions sont étroitement liées à la fréquence à laquelle elles sont soumises.

La présente invention a notamment pour but d'éviter de doubler l'amplificateur à faible bruit destiné à amplifier les signaux de réception avant leur conversion à une fréquence intermédiaire.

En effet, un appareil de radio-téléphonie d'un type conforme au paragraphe introductif est caractérisé en ce qu'il comprend un circuit de transformation muni d'une borne d'entrée dite asymétrique et de deux bornes de sortie formant une sortie dite symétrique, recevant sur son entrée asymétrique un signal de nature asymétrique délivré par un des systèmes d'antenne et de filtrage et fournissant à sa sortie symétrique un signal de sortie de nature symétrique à appliquer aux entrées d'un unique amplificateur à faible bruit, ledit circuit de transformation comportant un circuit symétriseur à entrée asymétrique et à sortie symétrique pouvant être accordé, au moyen d'une tension dite de commande d'accord délivrée par le dispositif de gestion de fréquences, sur l'une ou sur l'autre des deux gammes de fréquences.

Le circuit de transformation étant capable de traiter des signaux des deux gammes de fréquence, la présence d'un deuxième amplificateur à faible bruit n'est plus nécessaire lorsque l'amplificateur unique est capable d'amplifier des signaux des deux gammes de fréquences.

Selon un mode avantageux de mise en oeuvre de l'invention, l'appareil est en outre caractérisé en ce que le circuit symétriseur est du type à deux cellules en T disposées en parallèle dont les entrées sont connectées ensemble et forment ainsi l'entrée asymétrique du circuit symétriseur, chaque cellule étant formée d'une inductance de déphasage et d'une capacité de déphasage, le noeud intermédiaire à ces éléments formant la sortie de chaque cellule, les sorties des deux cellules formant la sortie symétrique du circuit symétriseur, les inductances et capacités de déphasage étant agencées en filtre passe-haut dans l'une des cellules et en filtre passe-bas dans l'autre, les capacités de déphasage étant des diodes à capacité variable soumises à la tension de commande d'accord.

Pour des raisons de commodité de réalisation, les inductances de déphasage ont une valeur qui est maintenue fixe. Les capacités de déphasage doivent donc pouvoir varier suivant le carré du rapport entre les fréquences utilisées. Dans le cas des systèmes GSM et DECT, les fréquences utilisées varient grossièrement d'un facteur deux ce qui entraîne la nécessité de faire varier les capacités de déphasage d'un facteur quatre. Cela est réalisable avec des diodes à capacité variable d'un type relativement standard.

L'impédance d'entrée de l'amplificateur à faible bruit est variable en fonction de la fréquence des signaux qu'il amplifie. Une variante de l'invention est caractérisée en ce que le circuit de transformation est muni de moyens d'adaptation d'impédance entre la sortie symétrique du circuit symétriseur et l'entrée de l'amplificateur à faible bruit.

Cette adaptation d'impédance au niveau du couplage du circuit symétriseur à l'amplificateur à faible bruit permet de minimiser les pertes de signal. Une telle adaptation d'impédance est mise en oeuvre dans un mode de réalisation préféré de l'invention caractérisé en ce que les moyens d'adaptation d'impédance comprennent :

- deux inductances identiques, dites d'adaptation série, dont la valeur est inférieure à celle des inductances de déphasage et qui sont connectées chacune entre la sortie d'une cellule en T et l'une des bornes de sortie formant la sortie symétrique du circuit de transformation,
- une capacité dite d'adaptation parallèle connectée entre les deux sorties des cellules en T,
- et une capacité dite d'adaptation série placée entre l'entrée asymétrique du circuit de transformation et celle du circuit symétriseur.

Par un choix convenable des éléments d'adaptation précités, l'impédance vue à la sortie du circuit symétriseur peut être adaptée à l'impédance d'entrée de l'amplificateur faible bruit bien que celle-ci varie fortement en fonction de la fréquence et dans un sens défavorable à cause de sa composante capacitive qui est due à la capacité parasite d'entrée de l'amplificateur. La structure des moyens d'adaptation d'impédance prévus selon l'invention est remarquable en ce qu'elle procure par des composants de valeurs fixes une adaptation optimale des impédances dans leur parties réelles ainsi qu'une compensation des parties réactives dans les deux gammes de fréquences utilisées. Une détermination précise des éléments indiqués se fera par exemple au moyen d'un programme d'ordinateur dans lequel seront introduites les caractéristiques de l'impédance d'entrée de l'amplificateur faible bruit. En ce qui concerne l'impédance présentée à l'entrée du circuit symétriseur, celle-ci est déterminée par les filtres de présélection de canaux pour lesquels une valeur de 50 Ohms est prévue le plus souvent.

La description qui va suivre en regard des dessins annexés, faite à titre d'exemple non limitatif, fera bien comprendre en quoi consiste l'invention et comment elle peut être réalisée, description dans laquelle :

- la figure 1 est un schéma fonctionnel partiel d'un appareil de radio-téléphonie selon l'invention, et
- la figure 2 est un schéma fonctionnel partiel d'un circuit de transformation inclus dans un appareil de radio-téléphonie selon un mode de réalisation préféré de l'invention.

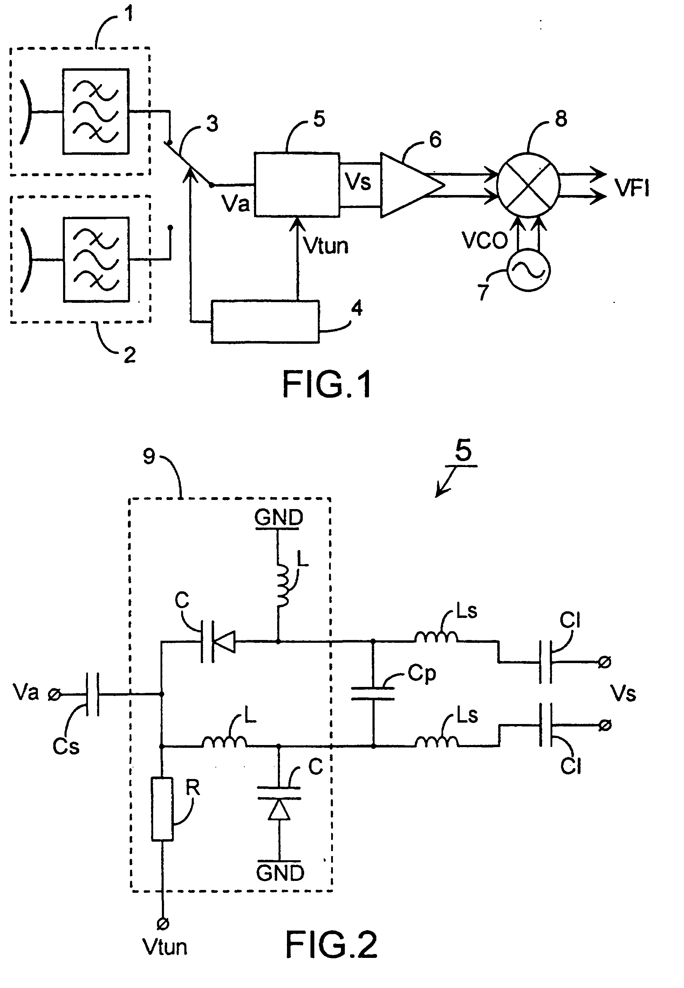

La figure 1 représente partiellement un appareil de radio-téléphonie selon l'invention, agencé pour émettre ou recevoir des signaux dans une première ou une deuxième gammes de fréquences. Dans le cadre de cette description, la première gamme de fréquences correspond à celle des signaux conformes à la norme GSM, dont la fréquence porteuse nominale F1 est de l'ordre de 950 MHz, et la deuxième gamme de fréquences correspond à celle des signaux conformes à la norme DECT, dont la fréquence porteuse nominale F2 est de l'ordre de 1880 MHz. L'appareil comprend un premier système d'antenne et de filtrage (1) destiné à assurer l'émission ou la réception de signaux dans la première gamme de fréquences, un deuxième système d'antenne et de filtrage (2) destiné à assurer l'émission ou la réception de signaux dans la deuxième gamme de fréquences, et un dispositif de sélection (3) de la gamme de fréquences utilisée ainsi qu'un dispositif de gestion de fréquences (4) pilotant ledit dispositif de sélection (3). Une conversion de fréquence, à partir de l'une des deux gammes de fréquences vers une fréquence intermédiaire FI, est réalisée par l'appareil au moyen d'un unique oscillateur local (7) délivrant à un mélangeur (8) un signal VCO dont la fréquence FLO est médiane entre les fréquences F1 et F2 de ces deux gammes. Le mélangeur (8) peut avantageusement comporter un dispositif permettant la réjection de la fréquence image et la compensation des défauts de linéarité de l'amplificateur à faible bruit (6). L'appareil comprend de plus un circuit de transformation (5) muni d'une borne d'entrée dite asymétrique et de deux bornes de sortie formant une sortie dite symétrique, recevant sur son entrée asymétrique un signal de nature asymétrique Va délivré par un des systèmes d'antenne et de filtrage (1 ou 2) et fournissant à sa sortie symétrique un signal de sortie de nature symétrique Vs à appliquer aux entrées d'un unique amplificateur à faible bruit (6). Le circuit de transformation (5) comporte un circuit symétriseur (9) à entrée asymétrique et à sortie symétrique, pouvant être accordé, au moyen d'une tension dite de commande d'accord Vtun délivrée par le dispositif de gestion de fréquences (4), sur l'une ou sur l'autre des deux gammes de fréquences. Le circuit de transformation (5) est en outre muni de moyens d'adaptation d'impédance entre la sortie symétrique du circuit symétriseur (9) et l'entrée de l'amplificateur à faible bruit (6).

L'oscillateur (7) et le mélangeur (8) opèrent, sur la base de la fréquence FLO, un changement par valeur inférieure depuis la fréquence F2 d'émission-réception la plus élevée, et par valeur supérieure depuis la fréquence F1 d'émission-réception la plus basse. La fréquence FLO du signal VCO fourni par l'oscillateur (7) est définie telle que FLO=(F2+F1)/2. Dans le cas présent, FLO sera donc de l'ordre de 1415 MHz. Lors de la réception d'un signal de fréquence F2, le mélangeur (8) restituera un signal de fréquence FI=F2-FLO=465 MHz, et lors de la réception d'un signal de fréquence F1, le mélangeur (8) restituera un signal de même fréquence FI=FLO-F1=465 MHz.

La figure 2 représente partiellement un circuit de transformation (5) inclus dans un appareil de radio-téléphonie selon un mode de réalisation préféré de l'invention. Un tel circuit de transformation (5) comprend un circuit symétriseur (9) du type à deux cellules en T disposées en parallèle dont les entrées sont connectées ensemble et forment ainsi l'entrée asymétrique du circuit symétriseur (9). Chaque cellule est formée d'une inductance de déphasage L et d'une capacité de déphasage C, le noeud intermédiaire à ces éléments formant la sortie de chaque cellule. Les sorties des deux cellules forment la sortie symétrique du symétriseur. Les inductances et capacités de déphasage L et C sont agencées en filtre passe-haut dans l'une des cellules et en filtre passe-bas dans l'autre, les capacités dé déphasage C étant des diodes à capacité variable soumises à la tension de commande d'accord Vtun. Ce ciruit de transformation (5) est en outre muni de moyens d'adaptation d'impédance qui comprennent :

- deux inductances identiques Ls, dites d'adaptation série, dont la valeur est inférieure à celle des inductances de déphasage L et qui sont connectées chacune entre la sortie d'une cellule en T et l'une des bornes de sortie formant la sortie symétrique du circuit de transformation (5),

- une capacité Cp dite d'adaptation parallèle connectée entre les deux sorties des cellules en T,
- et une capacité Cs dite d'adaptation série placée entre l'entrée asymétrique du circuit de transformation et celle du circuit symétriseur (9).

Le circuit de transformation (5) est enfin muni de deux capacités de liaison Cl, placées en série entre les inductances d'adaptation série Ls et les bornes de sortie formant la sortie symétrique du circuit de transformation (5).

Les valeurs des inductances de déphasage L sont fixes pour des raisons de commodité de réalisation. Les capacités C doivent donc pouvoir prendre deux valeurs, C1 et C2, correspondant respectivement à l'accord du circuit symétriseur (9) sur la fréquence F1 ou F2. Ces valeurs doivent alors respecter les deux relations :

$$L.C_1.(2.PI.F1)^2 = 1 \text{ et } L.C_2.(2.PI.F2)^2 = 1$$

Le rapport F2/F1 étant de l'ordre de 2, le rapport C1/C2 sera donc de l'ordre de 4. Une telle variation est rendue possible par l'emploi de diodes à capacités variables, dont les tensions de polarisation inverses, et donc les capacités, sont déterminées par deux valeurs différentes de la tension d'accord Vtun. Un choix de valeurs peut être, pour une même valeur L par exemple de l'ordre de 12nH, C1 de l'ordre de 2,5pF et C2 de l'ordre de 0,6pF. L'impédance de sortie du circuit symétriseur (9) variera donc, selon que celui-ci sera accordé sur la première ou la deuxième gamme de fréquence, les capacités de déphasage C prenant des valeurs différentes. Cependant, l'impédance d'entrée de l'amplificateur à faible bruit (6) prend, elle aussi, des valeurs différentes selon qu'il fonctionne dans la première ou la deuxième gamme de fréquence. Les éléments d'adaptation d'impédance Ls, Cp et Cs réalisent l'adaptation de l'impédance vue à la sortie du circuit symétriseur (9) à l'impédance d'entrée de l'amplificateur faible bruit (6). La structure des moyens d'adaptation d'impédance est remarquable en ce qu'elle procure par des composants de valeurs fixes une adaptation optimale des impédances dans leur parties réelles ainsi qu'une compensation des parties réactives dans les deux gammes de fréquences utilisées. Une détermination précise des éléments Ls, Cp et Cs pourra se faire au moyen d'un programme d'ordinateur dans lequel seront introduites les caractéristiques de l'impédance d'entrée de l'amplificateur faible bruit (6). Un tel programme d'ordinateur fournira, par exemple, les valeurs suivantes :

Ls=5,25nH, Cp=0,9pF et Cs=2,8pF

Les capacités de liaison C1 ont pour seul rôle d'éliminer les composantes continues des signaux transitant entre le circuit de transformation (5) et l'amplificateur à faible bruit (6) qui pourraient altérer la polarisation de l'amplificateur à faible bruit (6) et ainsi nuire au fonctionnement de l'appareil, comme par exemple la composante continue du signal de sortie Vs résultant de la tension d'accord Vtun. On choisira des valeurs de l'ordre de 10pF pour les capacités de découplage, afin qu'elles n'aient pas d'influence significative sur l'accord du circuit symétriseur (9), ni sur l'adaptation d'impédance entre celui-ci et l'amplificateur à faible bruit (6). De même, la résistance R recevant la tension de commande d'accord Vtun sera choisie comme étant relativement grande devant les impédances des autres éléments du circuit. On prendra par exemple R=10.000 Ohms.

## Revendications

1. Appareil de radio-téléphonie agencé pour émettre ou recevoir des signaux dans une première ou une deuxième gammes de fréquences, qui comprend un premier système d'antenne et de filtrage (1) destiné à assurer l'émission ou la réception de signaux dans la première gamme de fréquences, un deuxième système d'antenne et de filtrage (2) destiné à assurer l'émission ou la réception de signaux dans la deuxième gamme de fréquences, et un dispositif de sélection (3) de la gamme de fréquences utilisée ainsi qu'un dispositif de gestion de fréquences (4) pilotant ledit dispositif de sélection, appareil dans lequel une conversion de fréquence, à partir de l'une des deux gammes de fréquences vers une fréquence intermédiaire, est réalisée au moyen d'un unique oscillateur local (7) et d'un unique mélangeur (8), appareil **caractérisé en ce qu'**il comprend un circuit de transformation muni d'une borne d'entrée dite asymétrique et de deux bornes de sortie formant une sortie dite symétrique, recevant sur son entrée asymétrique un signal de nature asymétrique (Va) délivré par un des systèmes d'antenne et de filtrage et fournissant à sa sortie symétrique un signal de sortie de nature symétrique (Vs) à appliquer aux entrées d'un unique amplificateur à faible bruit (6), ledit circuit de transformation comportant un circuit symétriseur (9) à entrée asymétrique et à sortie symétrique pouvant être accordé, au moyen d'une tension dite de commande d'accord (Vtun) délivrée par le dispositif de gestion de fréquences, sur l'une ou sur l'autre des deux gammes de fréquences.

2. Appareil selon la revendication 1, **caractérisé en ce que** le circuit symétriseur est du type à deux cellules en T disposées en parallèle dont les entrées sont connectées ensemble et forment ainsi l'entrée asymétrique du circuit symétriseur, chaque cellule étant formée d'une inductance (L) de déphasage et d'une capacité (C) de déphasage, le noeud intermédiaire à ces éléments formant la sortie de chaque cellule, les sorties des deux cellules formant la sortie symétrique du circuit symétriseur, les inductances et capacités de déphasage étant agencées en filtre passe-haut dans l'une des cellules et en filtre passe-bas dans l'autre, les capacités de déphasage étant des diodes à capacité variable soumises à la tension de commande d'accord (Vtun).

3. Appareil selon l'une des revendications 1 ou 2, **caractérisé en ce que** le circuit de transformation (5) est muni de moyens d'adaptation d'impédance entre la sortie symétrique du circuit symétriseur et l'entrée de l'amplificateur à faible bruit et entre l'entrée asymétrique du circuit de transformation et celle du circuit symétriseur.

4. Appareil selon la revendication 3, **caractérisé en ce que** les moyens d'adaptation d'impédance comprennent :

   - deux inductances identiques (Ls), dites d'adaptation série, dont la valeur est inférieure à celle des inductances de déphasage et qui sont connectées chacune entre la sortie d'une cellule en T et l'une des bornes de sortie formant la sortie symétrique du circuit de transformation.
   - une capacité (Cp) dite d'adaptation parallèle connectée entre les deux sorties des cellules en T,
   - et une capacité (Cs) dite d'adaptation série placée entre l'entrée asymétrique du circuit de transformation et celle du circuit symétriseur.

**Patentansprüche**

1. Dafür angeordnetes Funkgerät, um Signale in einem ersten oder einem zweiten Frequenzband zu senden oder zu empfangen, welches ein erstes Antennen- und Filtersystem (1), das zur Bewerkstelligung des Sendens oder des Empfangens von Signalen in einem ersten Frequenzband bestimmt ist, ein zweites Antennen- und Filtersystem (2), das zur Bewerkstelligung des Sendens oder des Empfangens von Signalen in einem zweiten Frequenzband bestimmt ist und eine Vorrichtung zur Auswahl (3) des verwendeten Frequenzbandes sowie eine Vorrichtung zur Verwaltung der Frequenzen (4), welche die besagte Auswahlvorrichtung steuert, enthält, ein Gerät, in dem eine Frequenzwandlung anhand der einen der beiden Frequenzbänder in eine Zwischenfrequenz mit einem einzigen lokalen Oszillator (7) und einem einzigen Mischer (8) durchgeführt wird, **dadurch gekennzeichnete**s Gerät, dass es eine Umwandlungsschaltung enthält, die mit einer sogenannten asymmetrischen Eingangsklemme und mit zwei einen sogenannten symmetrischen Ausgang bildenden Ausgangsklemmen versehen ist, die an ihrem asymmetrischen Eingang ein Signal asymmetrischer Art (Va) erhält, von einem der Antennen- und Filtersysteme abgegeben, und an ihrem symmetrischen Ausgang ein Ausgangssignal symmetrischer Art (Vs) abgibt, den Eingängen eines einzigen rauscharmen Verstärkers (6) zuzuführen, wobei die besagte Umwandlungsschaltung eine Symmetrierschaltung (9) mit asymmetrischem Eingang und symmetrischem Ausgang aufweist, der mit einer sogenannten Abstimm-Steuerspannung (Vtun), die von einer Frequenzverwaltungsvorrichtung abgegeben wird, auf die eine oder andere der beiden Frequenzbänder abgestimmt werden kann.

2. Gerät nach Anspruch 1, **dadurch gekennzeichnet, dass** die Symmetrierschaltung des Typs mit zwei parallel angeordneten T-Zellen ist, deren Eingänge zusammengeschaltet sind und so den asymmetrischen Eingang der Symmetrierschaltung bilden, wobei jede Zelle aus einer Phasenverschiebungs-Induktanz (L) und einer Phasenverschiebungs-Kapazität (C) gebildet wird, der Zwischenknoten dieser Elemente den Ausgang jeder Zelle bildet, die Ausgänge der beiden Zellen den symmetrischen Ausgang der Symmetrierschaltung bilden, die Phasenverschiebungs-Induktanzen und Kapazitäten in einer der Zellen als Hochpassfilter und in der anderen als Tiefpassfilter angeordnet sind und die Phasenverschiebungs-Kapazitäten Dioden mit variabler Kapazität sind, die der Spannung der Abstimmsteuerung (Vtun) unterworfen sind.

3. Gerät nach Anspruch 1 oder 2, **dadurch gekennzeichnet, dass** die Umwandlungsschaltung (5) mit Mitteln zur Anpassung der Impedanz zwischen dem symmetrischen Ausgang der Symmetrierschaltung und dem Eingang des rauscharmen Verstärkers sowie zwischen dem asymmetrischen Eingang der Umwandlungsschaltung und dem der Symmetrierschaltung versehen ist.

4. Gerät nach Anspruch 1, **dadurch gekennzeichnet, dass** die Anpassungsmittel enthalten:

   - zwei identische Induktanzen (Ls) sogenannter Serienanpassung, deren Wert unter dem der Phasenverschiebungs-Induktanz liegt und die jeweils mit einem Ausgang einer T-Zelle und mit den Ausgangsklemmen verbunden sind, die den symmetrischen Ausgang der Umwandlungsschaltung bilden,
   - eine Kapazität sogenannter Parallelanpassung (Cp), zwischen den beiden Ausgängen der T-Zellen angeschlossen,

- und eine Kapazität sogenannter Serienanpassung (Cs), zwischen dem asymmetrischen Eingang der Umwandlungsschaltung und dem der Symmetrierschaltung angebracht.

## Claims

1. A radiotelephone arranged for transmitting or receiving signals in a first or second frequency band, comprising a first antenna and filter system (1) intended to ensure the transmission or reception of signals in the first frequency band, a second antenna and filter system (2) intended to ensure the transmission or reception of signals in the second frequency band, and a selection device (3) for selecting the frequency band used and a frequency management device (4) controlling said selection device, in which radiotelephone a frequency conversion from either frequency band to an intermediate frequency is realized by a single local oscillator (7) and a single mixer (8), which radiotelephone is **characterized in that** it comprises a transforming circuit which has an asymmetrical input terminal and two output terminals forming a symmetrical output, receiving on its asymmetrical input an asymmetrical signal (Va) produced by one of the antenna and filter systems and producing on its symmetrical output a symmetrical output signal (Vs) to be applied to the inputs of a single low-noise amplifier (6), said transforming circuit comprising a symmetrizing circuit (9) which has an asymmetrical input and a symmetrical output which can be tuned to either frequency band by means of a tuning control voltage (Vtun) produced by the frequency management device.

2. A radiotelephone as claimed in Claim 1, **characterized in that** the symmetrizing circuit has two T cells arranged in parallel whose inputs are connected together and thus form the asymmetrical input of the symmetrizing circuit, each cell being formed by a phase shifting inductance (L) and a phase shifting capacitor (C), the node between these elements forming the output of each cell, the outputs of the two cells forming the symmetrical output of the symmetrizing circuit, the phase shifting inductances and capacitors being arranged as a high-pass filter in one of the cells and a low-pass filter in the other, the phase shifting capacitors being variable capacitance diodes which are subjected to the tuning control voltage (Vtun).

3. A radiotelephone as claimed in one of the Claims 1 or 2, **characterized in that** the transforming circuit (5) includes impedance adapting means between the symmetrical output of the symmetrizing circuit and the input of the low-noise amplifier and the asymmetrical input of the transforming circuit and that of the symmetrizing circuit.

4. A radiotelephone as claimed in Claim 3, **characterized in that** the impedance adapting means comprise:

   - two identical inductances (Ls) called series adaptation inductances, whose value is lower than that of the phase shifting inductances and which are connected each between the output of a T-cell and one of the output terminals which form the symmetrical output of the transforming circuit,
   - one parallel adaptation capacitor (Cp) connected between the two outputs of the T-cells,
   - and one series adaptation capacitor (Cs) inserted between the asymmetrical input of the transforming circuit and that of the symmetrizing circuit.

FIG.1

FIG.2